# EUROPÄISCHE PATENTANMELDUNG

(11) **EP 0 798 808 A1**
(43) Veröffentlichungstag der Anmeldung: **01.10.1997**
(21) Anmeldenummer: 96117751.6
(22) Anmeldetag: 06.11.1996
(51) Int. Cl.: H01R 9/07, H05K 5/00, B60R 16/02

(54) **Anordnung zur Befestigung eines Kabelbaums an einer Trägerplatte**

(30) Priorität: 29.03.1996 DE 19612599
(71) Anmelder: ROBERT BOSCH GMBH, 70442 Stuttgart (DE)
(72) Erfinder: Bentz, Willy, 74343 Sachsenheim (DE); Hermanutz, Paul, 72810 Gomaringen (DE); Ernst, Waldemar, 71665 Vaihingen/Enz (DE)

(57) **Zusammenfassung**

Um eine Anordnung zur Befestigung eines Kabelbaums an einer Trägerplatte mit auflaminiertem Substrat für elektrische und/oder elektronische Bauelemente dahingehend zu verbessern, daß diese bei einfacher und damit kostengünstiger Herstellung eine hohe Zuverlässigkeit aufweist, wird vorgeschlagen, daß die Anschlußdrähte des Kabelbaums direkt mit elektrischen Anschlußelementen des Substrats elektrisch leitend verbunden sind, und daß der Kabelbaum im Bereich dieser Verbindung wenigstens teilweise in ein die Verbindung anschließendes Dichtmedium eingebettet ist.

## Beschreibung

### Stand der Technik

Die Erfindung betrifft eine Anordnung zur Befestigung eines Kabelbaums an einer Trägerplatte mit auflaminiertem Substrat für elektrische und/oder elektronische Bauelemente.

Derartige Anordnungen werden beispielsweise in der Fahrzeugelektronik eingesetzt, um einen Kabelbaum direkt mit einem Steuergerät des Fahrzeugs zu verbinden.

Dabei besteht die Forderung nach vormontierten, geprüften Einheiten, welche im allgemeinen auch einen motorseitigen Kabelbaum umfassen.

Aus der DE 40 23 319 C1 ist beispielsweise ein elektrisches Gerät, insbesondere ein Schalt- und Steuergerät für Kraftfahrzeuge bekannt, bei welcher die Verbindung des Kabelbaums mit der elektronischen Schaltung des Steuergeräts durch eine Steckerleiste hergestellt wird, die direkt auf der Trägerplatte befestigt ist.

Die Steckerleiste ist dabei außerhalb eines Gehäuses auf der Trägerplatte befestigt.

Nachteilig bei dieser Art der Befestigung des Kabelbaums ist die aufwendige Anordnung der Steckerleiste an der Trägerplatte. Darüber hinaus erweist sich die Steckverbindung selbst als störanfällig, so können beispielsweise die Kontaktstifte leicht korrodieren oder es kann durch Rütteln der gesamten Anordnung zu einer Kontaktunterbrechung kommen.

Der Erfindung liegt daher die Aufgabe zugrunde, eine Anordnung zur Befestigung eines Kabelbaums an einer Trägerplatte der gattungsgemäßen Art derart zu verbessern, daß diese bei einfacher und damit kostengünstiger Herstellung eine hohe Zuverlässigkeit aufweist.

### Vorteile der Erfindung

Diese Aufgabe wird bei einer Anordnung zur Befestigung eines Kabelbaumes an einer Trägerplatte der eingangs beschriebenen Art erfindungsgemäß dadurch gelöst, daß die Anschlußdrähte des Kabelbaums direkt mit elektrischen Anschlußelementen des Substrats elektrisch leitend verbunden sind und daß der Kabelbaum im Bereich dieser Verbindung wenigstens teilweise in ein die Verbindung einschließendes Dichtmedium eingebettet ist.

Die direkte Verbindung der Anschlußdrähte des Kabelbaums mit den elektrischen Anschlußelementen des Substrats und die Einbettung wenigstens eines Teils des Kabelbaums in ein die Verbindung einschließendes Dichtmedium hat den besonders großen Vorteil, daß eine langlebige, korrosionsunanfällige Befestigung des Kabelbaums an dem Substrat ermöglicht wird. Insbesondere kann durch diese Anordnung auch keine Kontaktunterbrechung durch Rütteln u.dgl. auftreten.

Darüber hinaus ist eine derartige Verbindung besonders einfach und daher kostengünstig herzustellen.

Rein prinzipiell wäre es möglich, eine zusätzliche Einrichtung zur Zugentlastung des Kabelbaums vorzusehen. Eine besonders vorteilhafte Lösung, die insbesondere auch hinsichtlich einer Gewichtseinsparung von großem Vorteil ist, sieht vor, daß das Dichtmedium gleichzeitig eine Zugentlastung bildet. Auf diese Weise kann die Zugentlastung auch gleichzeitig zusammen mit der Anordnung der Dichtung in einem Herstellungsgang und infolge davon besonders einfach und kostengünstig hergestellt werden.

Hinsichtlich der Anordnung der Anschlußdrähte auf den elektrischen Anschlußelementen des Substrats sind die unterschiedlichsten Ausführungen denkbar. Beispielsweise können die Anschlußdrähte des Kabelbaums direkt auf der Seite des Substrats mit den elektrischen Anschlußelementen verbunden sein, auf der auch die elektrischen und/oder elektronischen Bauelemente angeordnet sind.

Um insbesondere die Anordnung des zumeist in flüssiger Form verarbeiteten Dichtmediums zu erleichtern, ist vorzugsweise vorgesehen, daß die Trägerplatte im Bereich der Verbindung eine Aussparung aufweist, in der das den Kabelbaum aufnehmende Dichtmedium angeordnet ist.

In diesem Falle werden die Anschlußdrähte des Kabelbaums mit Anschlußelementen des Substrats verbunden, die auf der die elektrischen und/oder elektronischen Bauelemente tragenden abgewandten Seite des Substrats angeordnet ist.

Eine besonders vorteilhafte Ausführung sieht vor, daß die Trägerplatte gleichzeitig die Bodenplatte eines Gehäuses eines elektrischen/elektronischen Steuergeräts ist. Auf diese Weise können zusätzliche Befestigungsvorrichtungen des Kabelbaums in dem Gehäuse des elektrischen/elektronischen Steuergeräts entfallen.

Hinsichtlich der Anschlußelemente sind die unterschiedlichsten Ausführungen denkbar.

Beispielsweise ist vorgesehen, daß die Anschlußelemente Lötanschlüsse für eine Stempellötung sind.

Darüber hinaus können die Anschlußelemente auch eine mit dem Substrat elektrisch leitend verbundene Stiftleiste bilden.

### Zeichnung

Weitere Merkmale und Vorteile der Erfindung sind Gegenstand der nachfolgenden Beschreibung sowie der zeichnerischen Darstellung einiger Ausführungsbeispiele.

In der Zeichnung zeigen:
- Fig. 1: ein erstes Ausführungsbeispiel einer erfindungsgemäßen Anordnung zur Befestigung eines Kabelbaums an einer Trägerplatte;
- Fig. 2: ein zweites Ausführungsbeispiel einer erfindungsgemäßen Anordnung zur Befestigung eines Kabelbaums an einer Trägerplatte und
- Fig. 3: ein drittes Ausführungsbeispiel einer erfindungsgemäßen Anordnung zur Befestigung eines Kabelbaums an einer Trägerplatte.

### Beschreibung der Ausführungsbeispiele

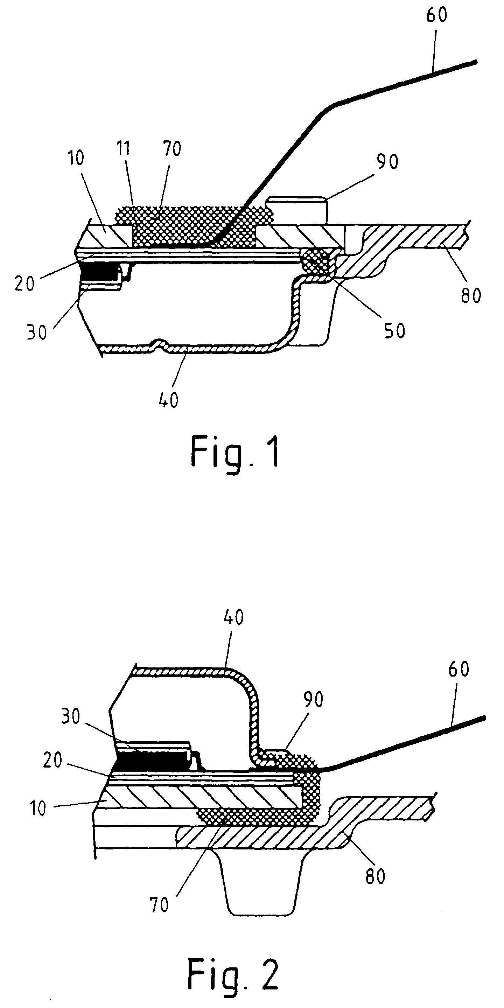

Ein Ausführungsbeispiel einer Anordnung zur Befestigung eines Kabelbaums 60 an einer metallischen Trägerplatte 10 mit auflaminiertem Substrat 20 ist in Fig. 1 dargestellt. Wie aus Fig. 1 hervorgeht, weist die Trägerplatte 10 im Bereich der Verbindung der Anschlußdrähte des Kabelbaums 60 mit (nicht dargestellten) Anschlußelementen des Substrats 20 eine Aussparung 11 auf, in der ein Dichtmedium 70 angeordnet ist, welches die gesamte Aussparung 11 und damit auch die Verbindung zwischen den Anschlußdrähten des Kabelbaums 60 und den Anschlußelementen des Substrats 20 einschließt.

Das Dichtmedium 70 kann beispielsweise aus PUR oder Silikon oder ähnlichem bestehen, es übernimmt gleichzeitig auch die Funktion einer Zugentlastung, da wenigstens ein Teil des Kabelbaums 60 in dem Dichtmedium 70 eingebettet ist.

Die Anschlußelemente auf dem Substrat 20 sind z.B. Löt-Anschlüsse, welche Kontaktstellen z.B. für eine Stempellötung mit dem Kabelbaum bilden.

Wie weiter aus Fig. 1 hervorgeht, sind auf dem Substrat 20 elektrische und/oder elektronische Bauelemente 30, beispielsweise - wie dargestellt - auf der der Verbindung abgewandten Seite des Substrats 20 angeordnet. Diese Bauelemente 30 befinden sich in einem von einem Gehäusedeckel 40 abgeschlossenen Gehäuse eines Steuergeräts für ein Kraftfahrzeug, das beispielsweise direkt mit Befestigungselementen 90, z.B. in Form von Schrauben, an einer Komponente der Brennkraftmaschine, z.B. einem Luftfiltergehäuse 80 befestigt ist.

Zwischen dem Gehäusedeckel 40 und der Trägerplatte 10 ist zur Abdichtung gegenüber Umwelteinflüssen ein Dicht- und/oder Klebemedium 50 angeordnet. Dabei bildet die metallische Trägerplatte 10 selbst eine Außenwand des Gehäuses, an welcher der Kabelbaum 60 besonders einfach auf die oben beschriebene Weise angeordnet werden kann.

Das in Fig. 2 dargestellte Ausführungsbeispiel unterscheidet sich von dem in Fig. 1 dargestellten dadurch, daß die elektrischen Anschlußdrähte des Kabelbaums 60 auf derselben Seite des Substrats 20 angeordnet sind, auf der auch die elektrischen und/oder elektronischen Bauelemente 30 angeordnet sind. In diesem Falle bildet das Dichtmedium 70 gleichzeitig eine Dichtung zwischen dem Gehäusedeckel 40 und der Trägerplatte 10 und eine gegenüber der Umgebung abdichtende Befestigung des in das Gehäuse geführten Kabelbaums 60. Darüber hinaus erfüllt auch bei dieser Anordnung das Dichtmedium 70 die Aufgaben einer Zugentlastung.

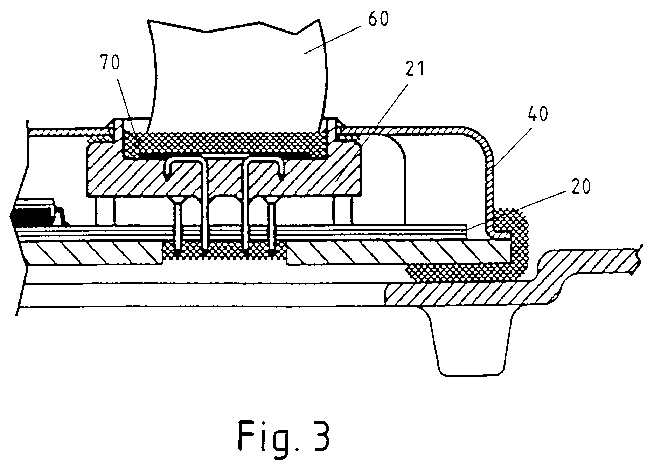

Wie bei der in Fig. 3 dargestellten weiteren Ausführungsform einer Anordnung zur Befestigung eines Kabelbaums 60 an einer metallischen Trägerplatte 10 mit auflaminiertem Substrat 20 gezeigt, ist es auch möglich, die Anschlußdrähte des Kabelbaums 60 nicht direkt mit Anschlußelementen auf der Oberfläche des Substrats 20 elektrisch leitend zu verbinden, sondern über eine eingelötete oder eingepreßte Stiftleiste 21. Durch diese Stiftleiste 21 wird ermöglicht, daß die Anschlagstelle des Kabelbaums 60 an eine Außenwand des Gehäuses, im vorliegenden Falle an einen Gehäusedeckel 40 geführt ist, so daß der Kabelbaum 60 nicht in das Gehäuse selbst bis zu dem Substrat 20 geführt werden muß.

Vorteilhaft bei den oben beschriebenen Ausführungsbeispielen ist, daß durch den direkten Anschluß der Anschlußdrähte des Kabelbaums 60 auf Anschlußelementen des Substrats 20 keine zusätzlichen Steckerleisten u.dgl. erforderlich sind, die störanfällig für Kontaktunterbrechungen, Korrosion u.dgl. sind, daß keine zusätzlichen Zugentlastungen erforderlich sind, daß diese Art des Anschlags des Kabelbaums 60 besonders einfach und damit auch kostengünstig zu realisieren ist und daß sich durch Wegfall zusätzlicher Anschlußelemente eine erhebliche Gewichtseinsparung ergibt.

## Patentansprüche

1. Anordnung zur Befestigung eines Kabelbaums (60) an einer Trägerplatte (10) mit auflaminiertem Substrat (20) für elektrische und/oder elektronische Bauelemente (30), **dadurch gekennzeichnet,** daß die Anschlußdrähte des Kabelbaums (60) direkt mit elektrischen Anschlußelementen des Substrats (20) elektrisch leitend verbunden sind und daß der Kabelbaum (60) im Bereich dieser Verbindung wenigstens teilweise in ein die Verbindung einschließendes Dichtmedium (70) eingebettet ist.

2. Anordnung nach Anspruch 1, dadurch gekennzeichnet, daß das Dichtmedium (70) gleichzeitig eine Zugentlastung bildet.

3. Anordnung nach Anspruch 1 oder 2, dadurch gekennzeichnet, daß die Trägerplatte (10) im Bereich der Verbindung eine Aussparung (11) aufweist, in der das den Kabelbaum (60) aufnehmende Dichtmedium (70) angeordnet ist.

4. Anordnung nach Anspruch 3, dadurch gekennzeichnet, daß die Trägerplatte (10) die Bodenplatte eines Gehäuses eines elektrischen/elektronischen Steuergerätes ist.

5. Anordnung nach Anspruch 1 bis 4, dadurch gekennzeichnet, daß die Anschlußelemente Lötanschlüsse für eine Stempellötung sind.

6. Anordnung nach Anspruch 1, dadurch gekennzeichnet, daß die Anschlußelemente eine mit dem Substrat (20) elektrisch leitend verbundene Stiftleiste (21) bilden.
